# EUROPEAN PATENT APPLICATION

(11) **EP 1 912 267 A1**
(43) Date of publication of application: **16.04.2008**
(21) Application number: 06782141.3
(22) Date of filing: 02.08.2006
(51) Int. Cl.: H01L 51/42

(54) **PHOTOELECTRIC CONVERSION ELEMENT**

(30) Priority: 02.08.2005 JP 2005224134; 21.04.2006 JP 2006118519
(71) Applicant: Adeka Corporation, Tokyo 116-8554 (JP); National University Corporation Hokkaido University, Sapporo-shi Hokkaido 060-0808 (JP)
(72) Inventor: MUSHA, Kiyoshi, c/o ADEKA CORPORATION, Tokyo 116-8554 (JP); TAKAHASHI, Tamotsu, Chuo-ku, Sapporo-shi, Hokkaido 064-0913 (JP)
(74) Representative: Forstmeyer, Dietmar
(86) International application number: PCT/JP2006/315272
(87) International publication number: WO 2007/015503

(57) **Abstract**

A photoelectric device including a positive electrode and a negative electrode facing each other and a photoelectric layer between the electrodes, the photoelectric layer having a stack of (1) a p type semiconductor layer and (2) a p type/n type mixed semiconductor layer and optionally (3) an n type semiconductor layer or a metal oxide layer. The photoelectric device has at least one photoelectric efficiency-improving means selected from (a) using an organic semiconductor thin film having a charge mobility of 0.005 cm²/V·sec or more as at least one of the semiconductor layers, (b) controlling the energy gap between the positive electrode work function and the HOMO of the p type layer (1) and/or the energy gap between the negative electrode work function and the LUMO of the n type layer (3) to 0.5 eV or less, and (c) providing an organic compound buffer layer between the positive electrode and/or the negative electrode and the photoelectric layer, the buffer layer and the positive electrode and/or the negative electrode being chemically bonded to each other.

## Description

### Technical Field

This invention relates to a photoelectric device that generates an electromotive force on irradiation with light.

### Background Art

Today, global warming due to the consumption of fossil fuels and increased energy demand accompanying population growth have posed serious problems fatal to mankind. Understandably, sunlight has been developing the global environment and has been an energy source for all living things including human beings from the earliest times to the present. It has recently been under study to utilize sunlight as an unlimited, clean (non-polluting) energy source. Among others, a photoelectric device that converts light energy to electrical energy, namely a solar cell has received attention as a promising technology.

Photovoltaic materials used in solar cells include inorganic semiconductors, such as single crystalline, polycrystalline or amorphous silicon and inorganic compound semiconductors, such as CuInSe, GaAs, and CdS. Attaining relatively high energy conversion efficiency between 10% and 20%, the solar cells using these inorganic semiconductors are widely used as power sources for remote areas or auxiliary power sources for portable electronic equipment. However, in the light of the above mentioned purpose of cutting back the fossil fuel consumption to prevent further deterioration of the environment, the state-of-the-art solar cells using the inorganic semiconductors cannot be seen as sufficiently effective for the following reasons. The solar cells using the inorganic semiconductor are produced by plasma enhanced CVD or high temperature crystal growth process, which require much energy. In addition, the inorganic semiconductors contain such components as can adversely affect the environment, such as Cd, As or Se. This involves a possibility that discarded photoelectric devices can lead to environmental destruction.

Organic solar cells using an organic semiconductor as a photovoltaic material that may overcome the above problems have been proposed. Organic semiconductors have excellent characteristics such as wide choice of material, low toxicity, good processability and productivity contributory to cost reduction, and flexibility enabling production of flexible devices. Organic solar cells that take full advantage of the organic semiconductors and are suitable for practical use have been studied extensively.

Organic solar cells are roughly divided into dye-sensitized type and semiconductor type. The dye-sensitized solar cell, which was reported by Gratzel, et al., Switzerland in 1991 and caught considerable attention, uses an electrode of a porous titanium dioxide thin film with a large surface area having absorbed thereon a ruthenium bipyridine carboxylic acid dye and a liquid electrolyte in contact with the electrode (see Non-Patent Document 1). However, to need high temperature in the treatment of titanium dioxide and to use a liquid electrolyte and iodine have been pointed out as problems, and this has been a bar to practical application. If the titanium dioxide treatment could be effected in low temperature, which enables film formation on a plastic substrate, and if a solid electrolyte could take the place of the liquid electrolyte, then this will obviously provide a great step toward the practical use of this type of organic solar cells. Although various trials have been made to realize low temperature treatment of titanium dioxide and to use a solid state electrolyte, none of them has achieved high photoelectric conversion efficiency. For example, applying conductive polymers such as polyaniline, polypyrrole, and polythiophene to an electrolyte portion has been investigated only to attain low conversion efficiency (see Non-Patent Document 2).

The semiconductor solar cells are further divided into Schottky barrier solar cells and pn junction solar cells according to the mechanism of separation of photogenerated charge pairs. Schottky barrier solar cells use the internal electric field by Schottky barrier formed at the interface between an organic semiconductor and metal (see Non-Patent Document 3). The Schottky barrier solar cells are characterized by achieving a relatively high open circuit voltage (Voc) but, on the other hand, tend to reduce in photoelectric conversion efficiency with increase in amount of incident light.

pn Junction solar cells utilize the internal electric field generated at the junction between a p type semiconductor and an n type semiconductor. The pn junction solar cells include those having organic matter as both p and n type semiconductors (organic/organic pn junction type) and those having inorganic matter as either one of the semiconductors (organic/inorganic pn junction type). The conversion efficiency reached by these organic pn junction solar cells is relatively high but not sufficient (see Non-Patent Document 4).

In conventional organic semiconductor solar cells, the thickness of the photoelectric layer formed by pn junction of organic semiconductors is only several nanometers, so that a mechanically stacked organic solar cell has poor light utilization, failing to achieve a high photocurrent. Therefore, improvement of light utilization efficiency by increasing the thickness of a photoelectric layer is said to be the key to the improvement of energy conversion efficiency of organic thin film solar cells. It has then been proposed to provide a layer of a mixture of a p type semiconductor and an n type semiconductor to introduce a molecular level three-dimensional pn junction thereby to achieve great improvement on conversion efficiency (see Non-patent Document 5).

However, evaluation of photoelectric characteristics with a continuously varying thickness of the mixed layer has revealed that light utilization efficiency increases with an increasing thickness to increase carrier generation but, in turn, the carrier transport properties are reduced. That is, there is a critical thickness of the mixed layer at which the energy conversion efficiency reaches the maximum. This is because the mixed layer contains both p type and n type molecules, so that the probability of generated carriers being recombined therein also increases. In many cases, the reduction in carrier transport properties is so influential that satisfactory efficiency cannot be obtained unless the film thickness is minimized. The p type and the n type semiconductor layers on both sides of the p/n mixed semiconductor layer also experience an increase of carrier separating performance at the cost of the carrier transport properties with an increase in film thickness, and there is a critical thickness for these layers at which the energy conversion efficiency is the maximum. The reduction in carrier transport properties is so influential in these layers that satisfactory efficiency cannot be obtained unless their thicknesses are minimized.

To provide a buffer layer near a photoelectric layer has been proposed in an attempt to improve conversion efficiency. For example, it has been proposed to provide a layer (10 to 100 nm thick) of poly(ethylenedioxy)thiophene-polystyrene sulfonic acid (PEDOT-PSS) on an ITO positive electrode side and a layer of bathocuproine (BCP) (about 10 nm thick) or LiF (a few nanometers thick) on a negative electrode side (see Non-Patent Document 6 and 7).

It is known that an organic compound semiconductor has varied characteristics, e.g., charge mobility, according to its crystal form so that it exhibits excellent photoelectric characteristics in a specific crystal form. It was attempted to obtain a specific crystal form in thin film formation by vacuum deposition by controlling the temperature of a substrate (see Non-Patent Document 8), but it has been difficult to obtain a semiconductor layer having a desired crystal form which exhibits high photoelectric characteristics.

A tandem solar cell having a stack of two or more pn junction cells has been reported (see Non-Patent Document 9).

Non-Patent Document 1: B. O'regan & M. Gratzel, Nature, 353, 737 (1991)
Non-Patent Document 2: K. Murakoshi, R. Kogure, Y. Wada, and S. Yanagida, Chemistry Letters, 1997, p. 471
Non-Patent Document 3: R.O. Loutfy et al., J. Chem. Phys., Vol. 71, p.1211
Non-Patent Document 4: C.W. Tang, Appl. Phys. Lett., 48(2), 13 Jan. 1986, p. 183
Non-Patent Document 5: Patent News, Research Institute of Economy, Trade and Industry, No. 11471, p. 8, Feb. 2, 2005
Non-Patent Document 6: P. Peumans, V. Bulovic, and S.R. Forrest, Appl. Phys. Lett., 76, 2650 (2000)
Non-Patent Document 7:C.J. Brabec, S.E. Shaheen, C. Winder, and N.S. Saricifci, Appl. Phys. Lett., 80, 1288 (2002)
Non-Patent Document 8: Z. Bao, A.J. Lovinger, and A. Dodabalapur, Appl. Phys. Lett., 69, 3066 (1996)
Non-Patent Document 9:M.Hiramoto, M.Suezaki, M.Yokoyama, Chemistry Letters 1990, p327

### Disclosure of the Invention

### Problem to be Solved by the Invention

Accordingly, an object of the present invention is to provide a photoelectric device that has good processability/productivity, low toxicity, and satisfactory photoelectric conversion efficiency and is flexible.

### Means for Solving the Problem

The conversion efficiency of organic thin film solar cells has conventionally been improved by forming a p/n mixed semiconductor layer to provide a greatly increased interface. The present inventors have noticed that the conversion efficiency is not so improved for the increase of the interface. It appears that most of the past discussions have been centered at how to transport excitons generated on light absorption to the interface where they are converted into carriers, lacking the viewpoint of how to transport the carriers staying at the interface.

The inventors have thought that the fact that a lot of carriers generated at the interface are not transported but recombined near the interface is one of great causes of the failure to achieve improved conversion efficiency for the increased interfacial area. Hence, the inventors have extensively studied on how to quickly transport the carries generated near the interface to the electrodes. As a result, they have found that the object is accomplished by using an organic semiconductor material having high carrier mobility.

Having been completed based on the above finding, the present invention (the invention of claim 1) provides a photoelectric device including a positive electrode and a negative electrode facing each other and a photoelectric layer interposed between the positive electrode and the negative electrode, wherein the photoelectric layer has (1) a p type semiconductor layer, (2) a p type/n type mixed semiconductor layer, and (3) an n type semiconductor layer stacked in the order described. The p type semiconductor of the p type semiconductor layer (1) and that of the mixed layer (2) may be the same or different, and the n type semiconductor of the mixed layer (2) and that of the n type semiconductor layer (3) may be the same or different. The photoelectric device has at least one of the following means for improving photoelectric efficiency.
(a) To use an organic semiconductor thin film having a charge mobility of 0.005 cm²/V·sec or more as at least one of the semiconductor layers (1) to (3).
(b) To control the energy gap between the work function of the positive electrode and the highest occupied molecular orbit (HOMO) of the p type semiconductor layer (1) and/or the energy gap between the work function of the negative electrode and the lowest unoccupied molecular orbit (LUMO) of the n type semiconductor layer (3) to 0.5 eV or less.
(c) To provide a buffer layer of an organic compound between the positive electrode and/or the negative electrode and the photoelectric layer, the buffer layer and the positive electrode and/or the negative electrode being chemically bonded to each other.

The invention (the invention of claim 2) also provides a photoelectric device comprising a positive electrode and a negative electrode facing each other and a photoelectric layer interposed between the positive electrode and the negative electrode, the photoelectric layer having (1) a p type semiconductor layer and (2) a p type/n type mixed semiconductor layer stacked on each other, the p type semiconductor of the p type semiconductor layer (1) and that of the mixed layer (2) being the same or different, wherein
the photoelectric device has at least one of the following means for improving photoelectric efficiency:
(a) to use an organic semiconductor thin film having a charge mobility of 0.005 cm²/V·sec or more as at least one of the semiconductor layers (1) and (2);
(b) to control the energy gap between the work function of the positive electrode and the highest occupied molecular orbit (HOMO) of the p type semiconductor layer (1) and/or the energy gap between the work function of the negative electrode and the lowest unoccupied molecular orbit (LUMO) of the n type semiconductor layer (3) to 0.5 eV or less; and
(c) to provide a buffer layer of an organic compound between the positive electrode and/or the negative electrode and the photoelectric layer, the buffer layer and the positive electrode and/or the negative electrode being chemically bonded to each other.

The present invention (the invention of claim 3) also provides, a photoelectric device comprising a positive electrode and a negative electrode facing each other and a photoelectric layer interposed between the positive electrode and the negative electrode, the photoelectric layer having (1) a p type semiconductor layer, (2) a p type/n type mixed semiconductor layer, and (3) a metal oxide layer stacked in that order, the p type semiconductor of the p type semiconductor layer (1) and that of the mixed layer (2) being the same or different, wherein
the photoelectric device has at least one of the following means for improving photoelectric efficiency:
(a) to use an organic semiconductor thin film having a charge mobility of 0.005 cm²/V·sec or more as at least one of the semiconductor layers (1) and (2);
(b) to control the energy gap between the work function of the positive electrode and the highest occupied molecular orbit (HOMO) of the p type semiconductor layer (1) and/or the energy gap between the work function of the negative electrode and the lowest unoccupied molecular orbit (LUMO) of the n type semiconductor layer of the mixed layer (2) to 0.5 eV or less; and
(c) to provide a buffer layer of an organic compound between the positive electrode and/or the negative electrode and the photoelectric layer, the buffer layer and the positive electrode and/or the negative electrode being chemically bonded to each other.

The present invention (the invention of claim 4) also provides the photoelectric device according to any one of claims 1 to 3, which adapts at least the photoelectric efficiency-improving means (a) (to use an organic semiconductor thin film having a charge mobility of 0.005 cm²/V·sec or more as at least one of the semiconductor layers).
The present invention (the invention of claim 5) also provides the photoelectric device according to any one of claims 1 to 4, wherein the p type semiconductor layer is an organic semiconductor thin film having a charge mobility of 0.005 cm²/V·sec or more.

The present invention (the invention of claim 6) also provides the photoelectric device according to claim 4 or 5, comprising a plurality of photoelectric units each comprising the photoelectric layer having the semiconductor layers, every adjacent photoelectric units being separated with a layer that forms an equipotential surface and/or a charge generation layer as an intermediate electrode.

The present invention (the invention of claim 7) also provides the photoelectric device according to any one of claims 1 to 3, which adapts at least the means (b) for improving photoelectric efficiency.
The present invention (the invention of claim 8) also provides the photoelectric device according to any one of claims 1 to 3, which adapts at least the means (c) is for improving photoelectric efficiency.
The present invention (the invention of claim 9) also provides the photoelectric device according to any one of claims 1 to 8, wherein the p type semiconductor layer (1) of the photoelectric layer has a thickness of 10 nm or greater.

The present invention (the invention of claim 10) also provides the photoelectric device according to any one of claims 1 to 9, wherein at least one of the organic semiconductor compounds used in the semiconductor layers is selected from polyacene derivatives represented by general formula (I):

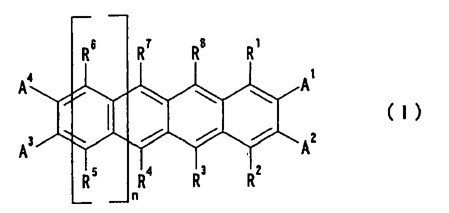

wherein R¹ R², R³, R⁴, R⁵, R⁶, R⁷, R⁸, A¹, A², A³, and A⁴ each independently represent a hydrogen atom, a halogen atom, a substituted or unsubstituted C₁ to C₄₀ hydrocarbon group, a substituted or unsubstituted C₁ to C₄₀ alkoxy group, a substituted or unsubstituted C₆ to C₄₀ aryloxy group, a substituted or unsubstituted C₇ to C₄₀ alkylaryloxy group, a substituted or unsubstituted C₂ to C₄₀ alkoxycarbonyl group, a substituted or unsubstituted C₇ to C₄₀ aryloxycarbonyl group, a cyano group (-CN), a carbamoyl group (-C(=O)NH₂), a haloformyl group (-C(=O)-X, wherein X represents a halogen atom), a formyl group (-C(=O)-H), an isocyano group, an isocyanate group, a thiocyanate group, a thioisocyanate group, a substituted or unsubstituted amino group, a substituted or unsubstituted amide group, a hydroxyl group, a substituted or unsubstituted silyl group, a substituted or unsubstituted thienyl group, or a functional group containing at least two of the groups recited; A¹ and A², or A³ and A⁴ may be connected to each other to form a ring represented by formula: -C(=O)-B-C(=O)- (wherein B is an oxygen atom or a group N(B¹)-(wherein B¹ is a hydrogen atom, a C₁ to C₄₀ hydrocarbon group, or a halogen atom)); A³ and A⁴ may be connected to each other to form a saturated or unsaturated, and substituted or unsubstituted C₄ to C₄₀ ring which may be interrupted with an oxygen atom, a sulfur atom or a group -N(R¹¹)- (wherein R¹¹ is a hydrogen atom or a hydrocarbon group); and n is an integer of 1 or greater.

The present invention (the invention of claim 11) also provides the photoelectric device according to any one of claims 1 to 10, wherein at least one of the p type semiconductor layer (1), the p type/n type mixed semiconductor layer (2), the n type semiconductor layer (3), and the metal oxide layer (3) is formed by a wet coating method.

### Best Mode for Carrying out the Invention

The present invention will be described in detail.

The photoelectric device which adapts the photoelectric efficiency improving means (a) (hereinafter referred to as a first embodiment) will be described first.
The photoelectric device of the first embodiment has the following characteristics. In a photoelectric device including a positive electrode and a negative electrode facing each other and a photoelectric layer interposed between the positive electrode and the negative electrode, the photoelectric layer has (1) a p type semiconductor layer, (2) a p type/n type mixed semiconductor layer, and (3) an n type semiconductor layer stacked in the order described. The p type semiconductor of the p type semiconductor layer (1) and that of the mixed semiconductor layer (2) may be the same or different, and the n type semiconductor of the mixed semiconductor layer (2) and that of the n type semiconductor layer (3) may be the same or different. The photoelectric device may optionally have a layer that does not interfere with smooth charge movement between any adjacent two of the semiconductor layers. At least one of the semiconductor layers (1) to (3) is a high-mobility organic semiconductor thin film.

The charge mobility of the high-mobility organic semiconductor thin film is preferably 0.005 cm²/V·sec or more, more preferably 0.01 cm²/V·sec or more, even more preferably 0.1 cm²/V·sec or more, still more preferably 0.4 cm²/V·sec or more, most preferably 1.0 cm²/V·sec or more.
There is no particular upper limit of the charge mobility of the organic semiconductor thin film. The higher, the better. The photoelectric layer composed of the semiconductor layers (1) to (3) is formed by providing the layer (1) on the positive electrode side and the layer (3) on the negative electrode side.

The photoelectric device may have a structure without the n type semiconductor layer (3). In this case, it is preferred that the p type semiconductor layer used in the p type/n type mixed semiconductor layer contain at least one polymer. Examples of the polymer include, but are not limited to, polymers of substituted or unsubstituted thiophene derivatives, substituted or unsubstituted polyphenylene derivatives, and substituted or unsubstituted polyphenylene vinylene derivatives. The n type semiconductors to be combined with preferably include C₆₀ derivatives and C₇₀ derivatives, such as C₆₀, C₇₀, and PCBM.

A photoelectric device having such a polymer-containing mixed semiconductor layer usually achieves a certain degree of photoelectric conversion efficiency simply by combining with electrodes and optionally a buffer layer(s) without a p type semiconductor layer (1) or an n type semiconductor layer (3). Seeing that the photoelectric efficiency is markedly improved by rapidly drawing the charges residing in the mixed layer as found by the inventors, adding a high-mobility organic semiconductor thin film (p type semiconductor) to the mixed layer brings about remarkable improvement on photoelectric efficiency. The thickness of the p type semiconductor layer is preferably 10 nm or more, more preferably 20 nm to 100 nm. The preference for the charge mobility of the high-mobility organic semiconductor thin film is identical to that described above and will not be redundantly described.

The photoelectric layer may have a structure composed of the p type semiconductor layer (1), the mixed semiconductor layer (2), and a metal oxide layer. Examples of the metal oxide include, but are not limited to, titanium oxide and tin oxide. In this configuration, too, addition of the high-mobility organic semiconductor thin film to the p type semiconductor device (1) brings about improvement on conversion efficiency.

The high-mobility organic semiconductor thin film having a charge mobility of 0.005 cm²/V·sec or more can be used as any of the layers (1) to (3).
In the case where the high-mobility organic semiconductor thin film is used as the layer (1), the charge carriers (electrons and holes) generated in the layer (2) are efficiently separated before they recombine because the holes are swept at a high speed. Furthermore, by the use of a high-mobility material that forms an organic semiconductor thin film with a charge mobility of 0.005 cm²/V·sec or more, the diffusion distance of holes becomes longer, which allows for increasing the film thickness. As a result, the holes are efficiently separated, and the light absorption increases to increase the amount of carriers (electrons and holes) generated, resulting in an increase of electrical current.

In the case where the high-mobility organic semiconductor thin film is used in the layer (2), the mechanism of obtaining improved conversion efficiency is believed to be as follows. It has been revealed that the greater the thickness of the mixed layer made of a low-mobility material, the higher the efficiency of light utilization becomes, with carrier generation augmented, though the carrier transport is reduced in contrast, presenting a thickness of the mixed layer for a maximum energy conversion efficiency. This may be attributed to the growth of probability of carrier recombination because of co-existing p and n type molecules within the mixed layer. Then, using the high-mobility material permits increasing the thickness of the mixed layer. It follows that light utilization is improved, carrier generation increases, carrier transport path increases, and the mixed layer thickness at which the energy conversion efficiency is the maximum increases. As a result, the energy conversion efficiency is further improved. Moreover, the probability of carrier recombination is smaller in the mixed layer (2) containing the high-mobility material than in a mixed layer containing a low-mobility material.

In the case where the high-mobility organic semiconductor thin film is used as the layer (3), the charge carriers (electrons and holes) generated in the layer (2) are efficiently separated before they recombine because the electrons are swept at a high speed. Furthermore, by the use of a high-mobility material, the traveling distance of electrons becomes longer, which allows for increasing the film thickness. As a result, the electrons are efficiently separated, and the light absorption increases to increase the amount of carriers (electrons and holes) generated, resulting in an increase of electrical current.

Using a high-mobility material provides an additional advantage as follows. Where a transparent electrode and the opposite electrode have a flat surface, incident light passes successively through the transparent electrode and the photoelectric semiconductor layer, reflects on the opposite electrode, and passes again through the photoelectric layer and the transparent electrode. If an electrode opposite to a transparent electrode has a textured, rough surface, light reflects diffusely on the textured surface, and the reflectance for confining light in the semiconductor layer increases. It follows that the light path length in the semiconductor layer increases, resulting in increased light absorption. In short, the light confinement structure, i.e., a textured structure achieves improved light absorption efficiency, which leads to improved conversion efficiency (see, e.g., JP 2005-2387A). The electrode surface roughness should be at least several tens of nanometers. Unless a high-mobility material is used, the film thickness cannot be increased, that is, the textured structure for obtaining improved conversion efficiency cannot be formed. It is not until the high-mobility material is used that the effect of the textured structure is obtained.

Each of the semiconductor layers (1) to (3) is formed as a thin film. The thickness of the p type semiconductor layer (1) is preferably 1 to 200 nm, more preferably 10 to 200 nm, even more preferably 20 to 100 nm. The thickness of the p type/n type mixed semiconductor layer (2) is preferably 5 to 200 nm, more preferably 10 to 100 nm. The thickness of the n type semiconductor layer, if provided, is preferably 1 to 200 nm, more preferably 5 to 100 nm.

The p type/n type mixed semiconductor layer (2) is preferably a molecular or nano level mixture of an n type and a p type semiconductor. A p type to n type semiconductor mixing ratio is preferably 1:0.1 to 1:5.0 by volume, more preferably 1:0.5 to 1:2.0 by volume.

The p type semiconductor layer (1), the p type/n type mixed semiconductor layer (2), and the n type semiconductor layer (3) are formed conveniently by methods known in the art of photoelectric devices (hereinafter described). When the p type/n type mixed semiconductor layer (2) is formed by vacuum deposition, while co-deposition is a method of choice, it is also possible to adapt a wet coating technique using a solution or a dispersion of both the p type and the n type semiconductors in an appropriate solvent, for example, spin coating.
Examples of the metal oxide used to form the metal oxide layer include, but are not limited to, titanium oxide and tin oxide. The metal oxide layer preferably has a thickness of 1 to 200 nm, more preferably 20 to 100 nm.

In the first embodiment of the photoelectric device of the invention, it is preferred that at least one of the semiconductor layers (1) to (3) contains, as a semiconductor compound, a polyacene derivative or a mixture of a polyacene derivative and other organic substance. The polyacene derivative is preferably one represented by general formula (I) shown below. The organic substances that may be mixed with the polyacene derivative preferably include oligomers and polymers. For example, organic substances that will improve charge mobility or stability when mixed with the polyacene derivative can be used.
The polyacene derivative represented by general formula (I) is particularly preferred for use in the invention. The polyacene derivative of general formula (I) will be described in detail.

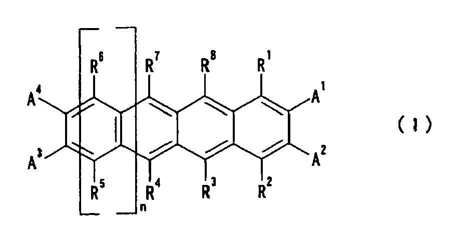

wherein R¹, R², R³, R⁴, R⁵, R⁶, R⁷, R⁸, A¹, A², A³, and A⁴ each independently represent a hydrogen atom, a halogen atom, a substituted or unsubstituted C₁ to C₄₀ hydrocarbon group, a substituted or unsubstituted C₁ to C₄₀ alkoxy group, a substituted or unsubstituted C₆ to C₄₀ aryloxy group, a substituted or unsubstituted C₇ to C₄₀ alkylaryloxy group, a substituted or unsubstituted C₂ to C₄₀ alkoxycarbonyl group, a substituted or unsubstituted C₇ to C₄₀ aryloxycarbonyl group, a cyano group (-CN), a carbamoyl group (-C(=O)NH₂), a haloformyl group (-C(=O)-X, wherein X represents a halogen atom), a formyl group (-C(=O)-H), an isocyano group, an isocyanate group, a thiocyanate group, a thioisocyanate group, a substituted or unsubstituted amino group, a substituted or unsubstituted amide group, a hydroxyl group, a substituted or unsubstituted silyl group, a substituted or unsubstituted thienyl group, or a functional group containing at least two of the groups recited; A¹ and A², or A³ and A⁴ may be connected to each other to form a ring represented by formula: -C(=O)-B-C(=O)- (wherein B is an oxygen atom or a group -N(B¹)-(wherein B¹ is a hydrogen atom, a C₁ to C₄₀ hydrocarbon group, or a halogen atom)); A³ and A⁴ may be connected to each other to form a saturated or unsaturated, and substituted or unsubstituted C₄ to C₄₀ ring which may be interrupted with an oxygen atom, a sulfur atom or a group -N(R¹¹)- (wherein R¹¹ is a hydrogen atom or a hydrocarbon group); and n is an integer of 1 or greater.

Examples of the halogen atom include fluorine, chlorine, bromine, and iodine.

The C₁ to C₄₀ hydrocarbon group may be saturated or unsaturated and cyclic or acyclic. The C₁ to C₄₀ hydrocarbon group which is acyclic may be linear or branched. Examples of the C₁ to C₄₀ hydrocarbon group include a C₁ to C₄₀ alkyl group, a C₂ to C₄₀ alkenyl group, a C₂ to C₄₀ alkynyl group, a C₃ to C₄₀ allyl group, a C₄ to C₄₀ alkyldienyl group, a C₄ to C₄₀ polyenyl group, a C₆ to C₁₈ aryl group, a C₆ to C₄₀ alkylaryl group, a C₆ to C₄₀ arylalkyl group, a C₄ to C₄₀ cycloalkyl group, and a C₄ to C₄₀ cycloalkenyl group.
The C₁ to C₄₀ alkyl group, the C₂ to C₄₀ alkenyl group, the C₂ to C₄₀ alkynyl group, the C₃ to C₄₀ allyl group, the C₄ to C₄₀ alkyldienyl group, and the C₄ to C₄₀ polyenyl group are preferably a C₁ to C₂₀ alkyl group, a C₂ to C₂₀ alkenyl group, a C₂ to C₂₀ alkynyl group, a C₃ to C₂₀ allyl group, a C₄ to C₂₀ alkyldienyl group, and a C₄ to C₂₀ polyenyl group, respectively, more preferably a C₁ to C₁₀ alkyl group, a C₂ to C₁₀ alkenyl group, a C₂ to C₁₀ alkynyl group, a C₃ to C₁₀ allyl group, a C₄ to C₁₀ alkyldienyl group, and a C₄ to C₁₀ polyenyl group, respectively.

Examples of the substituted or unsubstituted C₁ to C₄₀ alkyl group that can be used in the practice of the present invention as the substituted or unsubstituted C₁ to C₄₀ hydrocarbon group include, but are not limited to, methyl, ethyl, propyl, n-butyl, t-butyl, dodecanyl, trifluoromethyl, perfluoro-n-butyl, 2,2,2-trifluoroethyl, benzyl, and 2-phenoxyethyl.
Examples of the substituted or unsubstituted C₆ to C₁₈ aryl group that can be used in the practice of the invention as the substituted or unsubstituted C₁ to C₄₀ hydrocarbon group include, but are not limited to, phenyl, 2-tolyl, 3-tolyl, 4-tolyl, naphthyl, biphenyl, 4-phenoxyphenyl, 4-fluorophenyl, 3-carbomethoxyphenyl, and 4-carbomethoxyphenyl.
Examples of the substituted or unsubstituted C₂ to C₁₈ alkynyl group that can be used in the practice of the invention as the substituted or unsubstituted C₁ to C₄₀ hydrocarbon group include, but are not limited to, ethynyl.

Examples of the substituted or unsubstituted C₁ to C₄₀ alkoxy group that can be used in the practice of the present invention include, but are not limited to, methoxy, ethoxy, 2-methoxyethoxy, and t-butoxy.

Examples of the substituted or unsubstituted C₆ to C₄₀ aryloxy group that can be used in the practice of the present invention include, but are not limited to, phenoxy, naphthoxy, phenylphenoxy, and 4-methylphenoxy.

Examples of the substituted or unsubstituted C₇ to C₄₀ alkylaryloxy group that can be used in the practice of the invention include, but are not limited to, methylphenoxy, ethylphenoxy, propylphenoxy, and butylphenoxy.
Examples of the substituted or unsubstituted C₂ to C₄₀ alkoxycarbonyl group that can be used in the practice of the invention include, but are not limited to, those corresponding to the alkoxy groups recited above as examples of the substituted or unsubstituted C₁ to C₄₀ alkoxy group.
Examples of the substituted or unsubstituted C₇ to C₄₀ aryloxycarbonyl group that can be used in the practice of the invention include, but are not limited to, those corresponding to the aryloxy groups recited above as examples of the substituted or unsubstituted C₆ to C₄₀ aryloxy group.

The cyano group (-CN), carbamoyl group (-C(=O)NH₂), haloformyl group (-C(=O)-X, X: halogen), formyl group (-C(=O)-H), isocyano group, isocyanate group, thiocyanate group, or thioisocyanate group may be derived, e.g., from an alkoxycarbonyl group through common organic chemical techniques. The carbamoyl group (-C(=O)NH₂), haloformyl group (-C(=O)-X, X: halogen), formyl group (-C(=O)-H), and the like are interchangeable with a cyano group or an alkoxycarbonyl group.

Examples of the substituted or unsubstituted amino group that can be used in the practice of the invention include, but are not limited to, amino, dimethylamino, methylamino, methylphenylamino, and phenylamino.
Examples of the substituted or unsubstituted amide group that can be used in the practice of the invention include, but are not limited to, an acetamide group, a benzamide group, and a hexanamide group.

Examples of the substituted or unsubstituted silyl group include a group represented by formula: -Si(R¹²)(R¹³)(R¹⁴) (wherein R¹², R¹³, and R¹⁴ each independently represent a halogen-substituted or unsubstituted C₁ to C₄₀ alkyl group, a halogen-substituted or unsubstituted C₆ to C₄₀ arylalkyl group, a halogen-substituted or unsubstituted C₁ to C₄₀ alkoxy group, or a halogen-substituted or unsubstituted C₆ to C₄₀ arylalkyloxy group.

Examples of the silyl group that can be used in the practice of the invention include, but are not limited to, trimethylsilyl, triethylsilyl, trimethoxysilyl, triethoxysilyl, diphenylmethylsilyl, triphenylsilyl, triphenoxysilyl, dimethylmethoxysilyl, dimethylphenoxysilyl, and methylmethoxyphenyl.

The C₁ to C₄₀ hydrocarbon group, the C₁ to C₄₀ alkoxy group, the C₆ to C₄₀ aryloxy group, the amino group, the silyl group, and the like may have a substituent, such as a silyl group, a halogen atom, a hydroxyl group, or an amino group.

Examples of the halogen atom as a substituent include fluorine, chlorine, bromine, and iodine. Substitution of the hydrogen atom of the C₁ to C₄₀ hydrocarbon group, C₁ to C₄₀ alkoxy group, C₆ to C₄₀ aryloxy group, and so forth with a fluorine atom results in increased solubility of the polyacene derivative. When substituted with a triisopropylethynyl group, the polyacene derivative has enhanced stability.

A¹ and A², or A³ and A⁴ may be connected to form a ring represented by formula: -C(=O)-B-C(=O)-, wherein B is an oxygen atom or a group -N(B¹)- (wherein B¹ is a hydrogen atom, a C₁ to C₄₀ hydrocarbon group, or a halogen atom).
When, for example, A¹, A², A³, and A⁴ are each an alkoxycarbonyl group, they may be converted to a carboxyl group through a commonly employed organic chemical reaction, and the adjacent carboxyl groups can be dehydrated to form a carboxylic acid anhydride, i.e., a ring represented by -C(=O)-O-C(=O)-. The carboxylic anhydride may be converted into an imide ring represented by -C(=O)-N(B¹)-C(=O)- (wherein B¹ is as defined above) through a common organic chemical reaction.

A³ and A⁴ may be taken together to form a saturated or unsaturated C₄ to C₄₀ ring. The unsaturated ring may be an aromatic ring, such as a benzene ring or a thiophene ring. The ring formed by A₃ and A₄ is preferably a 4 to 16-membered ring, more preferably a 4 to 12-membered ring, which may be either aromatic or aliphatic and may have a substituent, e.g., a C₁ to C₂₀ hydrocarbon atom, a C₁ to C₂₀ alkoxy group, a C₆ to C₂₀ aryloxy group, an amino group, a hydroxyl group, or a silyl group.
The saturated or unsaturated ring may be interrupted with an oxygen atom, a sulfur atom or a group N(R¹¹)-, wherein R¹¹ is a hydrogen atom or a hydrocarbon group. R¹¹ is preferably a hydrogen atom or a C₁ to C₆ alkyl group, more preferably a hydrogen atom or a C₁ to C₄ group.

n is an integer of 1 or greater. When n is 1 or 2, the polyacene derivative represented by general formula (I) is a tetracyclic or pentacyclic compound, i.e., a naphthacene or pentacene derivative, respectively.
A fused polycyclic aromatic compound tends to have reduced solubility with an increasing number of the aromatic rings. In contrast, even if the number of the aromatic rings increases, solubility can be retained by introducing a proper substituent in accordance with the process of preparation described later. Therefore, n is not limited to 1 or 2 and may be 3, 4, 5 or even greater. While there is no particular upper limit of the number n, 1 or 2 or so would be convenient in view of certainty of solubility and production cost.

At present, unsubstituted pentacene is known to have the highest carrier mobility among known organic compounds and has been studied extensively. However, it is difficult to form a thin film of pentacene by a wet coating method such as spin coating because of its solvent insolubility. Thin film formation is generally done by vacuum deposition. Of the polyacene derivatives of general formula (I) those in which at least one of R¹, R², R³, R⁴, R⁵, R⁶, R⁷, R⁸, A¹, A², A³, and A⁴ is not a hydrogen atom can be designed on the molecular level to be soluble in a solvent and thereby to provide a thin film by a wet coating technique such as spin coating. Wet coating achieves markedly improved processability and productivity compared with vacuum deposition. It is possible to control the crystallinity of the thin film by taking advantage of self-assembly achieved by proper selection of the compound per se, intermolecular action, and the solvent.

The photoelectric device which adapts the photoelectric efficiency improving means (b) (hereinafter referred to as a second embodiment) will then be described.
The photoelectric device of the second embodiment is characterized in that the energy gap between the work function of the positive electrode and the highest occupied molecular orbit (HOMO) of the p type semiconductor layer (1) and/or the energy gap between the work function of the negative electrode and the lowest unoccupied molecular orbit (LUMO) of the n type semiconductor layer (3) is/are 0.5 eV or less, preferably 0.3 eV or less. If the energy gap is large in sweeping charges to the electrodes, the holes or electrons generated in the photoelectric layer will be lost. To reduce the loss, the energy gap is 0.5 eV or less, preferably 0.3 eV or less.

In the second embodiment of the photoelectric device of the invention, it is preferred that at least one of the semiconductor layers (1) to (3) contains, as a semiconductor compound, a polyacene derivative or a mixture of a polyacene derivative and other organic substance. The polyacene derivative is preferably the one previously described that is represented by general formula (I). The organic substances that may be mixed with the polyacene derivative preferably include oligomers and polymers. For example, organic substances that will improve charge mobility or stability when mixed with the polyacene derivative can be used.

The description on the first embodiment applies to the second embodiment with respect to the particulars not specifically described.

The photoelectric device which adapts the photoelectric efficiency improving means (c) (hereinafter referred to as a third embodiment) will then be described.
The photoelectric device of the third embodiment is characterized in that a buffer layer of an organic compound is provided between each electrode and the semiconductor sublayer and that the organic compound of the buffer layer and the electrode are chemically bonded to each other. This buffer layer is what we call a self-assembled monolayer.
While there are various energy barriers in extracting charges from the photoelectric layer to the opposing electrodes, the problem is greatly reduced where the organic compound of the buffer layer and the electrode are chemically bonded to each other. In addition, there are possibilities that consideration of the work function of the electrode is no more necessary and that the molecular orientation of the organic semiconductor layer in contact with the buffer layer is controllable. A charge mobility is not a characteristic value inherent to a compound but varies in a range depending on the compound. That is, a charge mobility is measured on a thin film and is known to be dependent on the molecular orientation or crystallinity in the thin film. It is preferred for the organic semiconductor in the photoelectric layer to have a controlled molecular orientation. Control of the molecular orientation of the buffer layer compound in contact with the electrode can provide control of the molecular orientation of the compound of the organic semiconductor layer in contact with the buffer layer. The molecular orientation of the buffer layer could be controllable by selection of the kind, site, and amount of the functional group bondable to the electrode-forming material, e.g., metal. An elaborated control will provide a thin film having a molecular orientation favorable to the organic semiconductor layer, which enables the formation of a thin film with high charge mobility as contemplated in the invention.

In order to cause the electrode and the organic compound of the buffer layer to chemically bond to each other, it is preferred that the organic compound of the buffer layer have a functional group containing a hetero atom such as nitrogen, oxygen, sulfur or phosphorus. An organic compound containing sulfur, particularly a thiol group (-SH) is still preferred. In, for example, using a thiol group-containing organic compound, the electrode is preferably a gold electrode, inclusive of a gold thin film or a gold-containing electrode. A chemical bond between the organic compound of the buffer layer and the electrode is exemplified by an Au-S- bond formed by the reaction between gold (Au) of an electrode and a thiol-containing organic compound of a buffer layer. Such a chemical bond is formed by causing a gold electrode (inclusive of a gold thin film or a gold-containing electrode) and a thiol-containing compound. A compound having a -COOH group also exemplifies the organic compound of the buffer layer.
Specific examples of the organic compound of the buffer layer include benzenethiol and polycyclic aromatic compounds such as naphthalenetiol, anthracenethiol, and anthracenecarboxylic acid.

Any conventional method can be used to form a chemical bond between an electrode and an organic compound of a buffer layer. The following is an example.
In the case when the formation of a buffer layer precedes the formation of a photoelectric layer, an organic compound for the buffer layer is dissolved in an appropriate solvent (e.g., THF) in a concentration of about 0.01 to 20 % by mass to prepare a solution of the organic compound. An electrode substrate is dipped in the solution, rinsed with an appropriate solvent, and dried to form, on the electrode, a buffer layer in which the organic compound forms a chemical bond with the electrode. A buffer layer chemically bonded to an electrode may also be formed by vacuum depositing the organic compound of the buffer layer. A photoelectric layer is then formed on the buffer layer by various methods described layer. In the case when the formation of a photoelectric layer precedes the formation of a buffer layer, a buffer compound is deposited by vacuum evaporation on the photoelectric layer, and an electrode substance is deposited thereon by vacuum evaporation to form an electrode. In this case, too, the electrode and the buffer layer organic compound are chemically bonded to each other.

The buffer layer is provided in the form of a thin film, which may be a monolayer.

In the third embodiment of the photoelectric device of the invention, it is preferred that at least one of the semiconductor layers (1) to (3) contains, as a semiconductor compound, a polyacene derivative or a mixture of a polyacene derivative and other organic substance. The polyacene derivative is preferably the one previously described that is represented by general formula (I).

The description on the first embodiment applies to the third embodiment with respect to the particulars not specifically described.

Another preferred embodiment of the photoelectric device adapting the photoelectric efficiency improving means (a) will be described below (this embodiment is referred to as a fourth embodiment).
The photoelectric device of the fourth embodiment is characterized by having a plurality of photoelectric units between a positive electrode and an opposing negative electrode, every adjacent photoelectric units being separated with a layer that forms an equipotential surface and/or a charge generation layer as an intermediate electrode. Each of the photoelectric units comprises the photoelectric layer having (1) a p type semiconductor layer and (2) a p type/n type mixed semiconductor layer, and, optionally, (3) an n type semiconductor layer or a metal oxide layer stacked in that order. The p type semiconductor of the p type semiconductor layer (1) and that of the mixed semiconductor layer (2) may be the same or different, and the n type semiconductor of the mixed semiconductor layer (2) and that of the n type semiconductor layer (3) may be the same or different. The photoelectric device may optionally have a layer that does not interfere with smooth charge movement between any adjacent two of the layers. At least one of the semiconductor layers (1) to (3) of each photoelectric layer is an organic semiconductor thin film having a charge mobility of 0.005 cm²/V·sec or more.

In order to make effective use of the whole spectrum of sunlight, it is effective to stack photoelectric units. Because of the limited thickness of the photoelectric layer of organic semiconductors, a single photoelectric unit has difficulty in absorbing 100% of light in a certain limited wavelength range. It is difficult, too, to develop a semiconductor material having absorption over the whole spectrum of sunlight. Then photoelectric units containing semiconductor materials different in absorption wavelength region are stacked to effectively utilize sunlight. While simply stacking conventional pn junction devices hardly achieves good results, stacking the photoelectric devices of the present invention accomplishes high efficiency.

In the fourth embodiment of the invention, although the number of photoelectric units to be stacked is not particularly limited, it is preferable to stack two or three units or so in view of the balance between achievable improvement of photoelectric efficiency and the cost incurred.

The layer that forms an equipotential surface as an intermediate electrode is provided in a thin film form on the photoelectric unit using, for example, ITO (indium tin oxide), IZO (indium zinc oxide), Ag, Au, a fullerene, or an oligothiophene. The layer forming an equipotential surface preferably has a thickness of 0.1 to 50 nm.
The charge generation layer as an intermediate electrode is provided in a thin film form on the photoelectric unit using, for example, an arylamine (e.g., N,N'-diphenyl-N,N'-di(m-tolyl)benzidine or 4,4',4"-tris(N-3-methylphenyl-N-phenylamino)triphenylamine), a metal oxide (e.g., V₂O₅) or an electron-accepting compound (e.g., tetrafluorotetracyanoquinodimethane). The charge generation layer preferably has a thickness of 0.1 to 50 nm.

The photoelectric device of the fourth embodiment preferably has a buffer layer formed between each electrode and the semiconductor layer with a chemical bond with the electrode similarly in the third embodiment.
In the fourth embodiment, it is preferred that at least one of the semiconductor layers (1) to (3) contain, as a semiconductor compound, a polyacene derivative or a mixture of a polyacene derivative and other organic substance. The polyacene derivative is preferably the one previously described that is represented by general formula (I).

While the photoelectric device of the invention has been described with particular reference to the four embodiments, photoelectric devices possessing the characteristics of two or more of the embodiments are also included under the scope of the present invention.

The photoelectric device of the invention will be illustrated in more detail. The description hereunder applies to any of the foregoing four embodiments. It should be appreciated that the configuration of the photoelectric device according to the invention is not limited by the description hereunder.

The photoelectric device of the invention may have a structure in which a substrate, an electrode A, a photoconductive layer, an electrode B, and a coating layer are stacked in that order; a structure in which a substrate, an electrode A, a photoconductive layer, an intermediate electrode, a photoelectric layer, an electrode B, and a coating layer are stacked in that order; or a structure in which a substrate, an electrode A, a photoconductive layer, an intermediate electrode, a photoelectric layer, an intermediate electrode, a photoelectric layer, an electrode B, and a coating layer are stacked in that order, wherein the electrode A is a positive electrode, and the electrode B is a negative electrode.

A photoelectric device must allow light incident on either the electrode A side or the electrode B side to reach the photoelectric layer. In order to allow the light incident on the substrate to pass through the electrode A and reach the photoelectric layer, the substrate and the electrode A must be made of a material transparent to light. Likewise, in order to allow the light incident on the coating layer to pass through the electrode B and reach the photoelectric layer, the coating layer and the electrode B must be made of a material transparent to light. In order to allow light incident from both sides to reach the photoelectric layer, all the substrate, electrodes A and B, and coating layer must be formed of a light transmitting material.

The substrate is not limited in material and thickness as long as capable of stably holding the electrode A on its surface. The substrate may have a plate or a film form. Examples of the material of the substrate include metals or alloys such as aluminum and stainless steel, plastics such as polycarbonate and polyester, wood, paper, and fabric. When the device is designed to receive light from the substrate side, the substrate must be made of a light transmitting substance (material) as exemplified by transparent glass or transparent plastics. As used herein, the term "transparent" means a property of transmitting light of a prescribed wavelength region contemplated to be used for the photoelectric device, for example, visible light at a high percentage. While the photoelectric device is preferably built up on a substrate, a substrate may be dispensed with when the electrode A has rigidity enough to self-support. In that case, the electrode A also functions as a substrate.

It is desirable for the electrode A to have a work function of 4.5 V or more, more preferably 4.8 V or more, so that it may form a nearly ohmic junction with the organic p type semiconductor compound present in the photoelectric layer. On the other hand, it is desirable for the electrode B to have a work function of 4.5 V or less so that it may form a nearly ohmic function with the n type semiconductor compound. In the present invention, the facing pair of electrodes are designed to have a higher or lower work function relative to each other, i.e., to have different work functions. In the foregoing embodiments, the electrode A is designed to have a larger work function than the electrode B. The difference in work function between the two electrodes is preferably 0.5 V or more. In some cases where a buffer layer is provided between an electrode and a semiconductor layer with a chemical bond formed between the buffer layer and the electrode, the above described restriction about work function may be relaxed.

Materials of the electrodes A and B are chosen appropriately from metals, e.g., gold, platinum, and silver; metal oxides, e.g., zinc oxide, indium oxide, tin oxide (NESA), tin-doped indium oxide (ITO), and fluorine-doped tin oxide (FTO); lithium, lithium-indium alloys, sodium, sodium-potassium alloys, calcium, magnesium, magnesium-silver alloys, magnesium-indium alloys, indium, ruthenium, titanium, manganese, yttrium, aluminum, aluminum-lithium alloys, aluminum-calcium alloys, aluminum-magnesium alloys, graphite thin film; and organic conductive compounds such as PEDOT-PSS. These electrode materials may be used either individually or as a combination of two or more thereof. The electrodes A and B are each formed by, for example, vacuum deposition, sputtering, ionized deposition, ion plating, or a cluster ion beam method using these materials. The electrode may also be formed by a sol-gel firing process. The negative electrode may have a single layer or a multi-layered structure. The thickness of each electrode is generally about 5 to 1000 nm, preferably about 10 to 500 nm, while depending on the electrode material. At least one of the electrodes should be transparent or semitransparent and is preferably designed to have a light transmittance of 70 % or higher by properly selecting the material and thickness.

The polyacene derivative represented by general formula (I) that can be used in the photoelectric device of the invention serves as either p type or n type organic semiconductor compound depending on its structure. In general, a polyacene skeleton having an electron withdrawing functional group as a substituent acts as a p type semiconductor, whereas one having a substituent other than an electron withdrawing group acts as an n type. A p type or n type organic semiconductor compound can also be obtained by doping with a known substance. Examples of the electron withdrawing functional group include a carbonyl group, a cyano group, a nitro group, a sulfonyl group, a phosphonyl group, a halogen atom, and functional groups having the recited electron withdrawing group bonded thereto. The polyacene derivative for use as an n type organic semiconductor compound preferably has the electron withdrawing group at any of A¹, A², A³, and A⁴.

While it is preferred to use, as a semiconductor compound in the photoelectric device of the invention, the polyacene derivative represented by general formula (I), other known semiconductor compounds may be used as well. In the first embodiment where it is essential for the photoelectric device of the first embodiment to use a high mobility material in at least one layer of the photoelectric layer, the other layer(s) may be formed of other known semiconductor compounds. The organic semiconductor layer containing the polyacene derivative may be a layer formed solely of one of the polyacene derivatives, formed of two or more of the polyacene derivatives, or formed of a mixture of the polyacene derivative and other known semiconductor compound(s).

The other p type semiconductor compounds that can be used in the invention are exemplified by phthalocyanine pigments, indigo or thioindigo pigments, and quinacridone pigments. Other compounds having a hole injecting and transporting function that can be used in the invention are exemplified by triarylmethane derivatives, triarylamine derivatives, oxazole derivatives, hydrazone derivatives, stilbene derivatives, pyrazoline derivatives, polysilane derivatives, polyphenylene vinylene and its derivatives, polythiophene and its derivatives, and poly-N-vinylcarbazole derivatives. Examples of the triarylamine derivatives include 4,4'-bis[N-phenyl-N-(4"-methylphenyl)amino]biphenyl, 4,4'-bis[N-phenyl-N-(3"-methylphenyl)amino]biphenyl, 4,4'-bis[N-phenyl-N-(3"-methoxyphenyl)amino]biphenyl, 4,4'-bis[N-phenyl-N-(1"-naphthyl)amino]biphenyl, 3,3'-dimethyl-4,4'-bis[N-phenyl-N-(3"-methylphenyl)amino]biphenyl, 1,1-bis[4'-N,N-di(4"-methylphenyl)amino]phenyl]cyclohexane, 9,10-bis[N-(4'-methylphenyl)-N-(4"-n-butylphenyl)amino]phenanthrene, 3,8-bis(N,N-diphenylamino)-6-phenylphenanthridine, 4-methyl-N,N-bis[4",4"'-bis[N',N'-di(4-methylphenyl)amino]biphen-4-yl]aniline, N,N'-bis[4-(diphenylamino)phenyl]-N,N'-diphenyl-1,3-diaminobenzene, N,N'-bis[4-(diphenylamino)phenyl]-N,N'-diphenyl-1,4-diaminobenzene, 5,5"-bis[4-(bis[4-methylphenyl]amino)phenyl]-2,2' :5',2"-terthiophene, 1,3,5-tris(diphenylamino)benzene, 4,4',4"-tris(N-carbazolyl)triphenylamine, 4,4',4"-tris[N-(3'"-methylphenyl)-N-phenylaminotriphenylamine, 4,4',4"-tris[N,N-bis(4"'-tert-butylbiphen-4""-yl)amino]triphenylamine, and 1,3,5-tris[N-(4'-diphenylaminophenyl)-N-phenylamino]benzene. The compounds having a hole injecting and transporting function may be used either individually or as a combination of two or more thereof.

The other n type semiconductor compounds that can be used in the invention are exemplified by perylene pigments, perynone pigments, polycyclic quinone pigments, azo pigments, and C₆₀ fullerene or C₇₀ fullerene and their derivatives as organic compounds; and zinc oxide, titanium oxide, and cadmium sulfide as inorganic compounds. Further included in useful n type semiconductor compounds are organic metal complexes, e.g., tris(8-quinolinolato)aluminum, bis(10-benzo[h]quinolinolato)beryllium, 5-hydroxyflavone beryllium salt, and 5-hydroxyflavone aluminum salt; oxadiazole derivatives, e.g., 1,3-bis[5'-(p-tert-butylphenyl)-1,3,4-oxadiazol-2'-yl]benzene; triazole derivatives, e.g., 3-(4'-tert-butylphenyl)-4-phenyl-5-(4"-biphenyl)-1,2,4-triazole; phenanthroline derivatives, e.g., 2,9-dimethyl-4,7-diphenyl-1,10-phenanthroline (bathocuproine, BCP); triazine derivatives, quinoline derivatives, quinoxaline derivatives, diphenylquinone derivatives, nitro-substituted fluorenone derivatives, and thiopyrane dioxide derivatives.

The methods of forming the photoelectric layer are not particularly limited. For example, the semiconductor layers (1) to (3) may be formed in a thin film form by vacuum deposition, ionized deposition, or wet coating techniques including spin coating, casting, dip coating, bar coating, roll coating, the Langmuir-Blodgett method, and an inkjet method. When each layer is formed by vacuum deposition, vacuum deposition is preferably but not necessarily carried out under the following conditions: a vacuum of about 10⁻⁵ Torr, a boat temperature (evaporation source temperature) of about 50° to 600°C, a substrate temperature of about -50° to 300°C, and a deposition rate of about 0.005 to 50 nm/sec. When two or more layers are formed continuously in a vacuum system, there will be obtained the photoelectric device with further improvements in various characteristics. Where a layer is formed by vacuum deposition using two or more compounds, the temperatures of the boats containing the respective evaporation sources (compounds) to be co-deposited are preferably controlled individually.

When each layer is formed by wet coating, a component forming the layer and, if necessary, a binder resin and any other component are dissolved or dispersed in an appropriate solvent to prepare a coating composition, which is applied by various methods to form a thin film. Examples of useful binder resins include poly-N-vinylcarbazole, polyacrylate, polystyrene, polyester, polysiloxane, polymethyl acrylate, polymethyl methacrylate, polyether, polycarbonate, polyamide, polyimide, polyamide-imide, poly-p-xylene, polyethylene, polyethylene ether, polypropylene ether, polyphenylene oxide, polyether sulfone, polyaniline and its derivatives, polythiophene and its derivatives, polyphenylene vinylene and its derivatives, polyfluorene and its derivatives, polythienylene vinylene and its derivatives. These binder resins may be used either individually or as a combination thereof.

Examples of the solvents that can be used to dissolve or disperse the layer-forming component, the binder resin, etc. include organic solvents and water. Examples of the organic solvents include hydrocarbons such as hexane, octane, decane, toluene, xylene, ethylbenzene, and 1-methylnaphthalene; ketones such as acetone, methyl ethyl ketone, methyl isobutyl ketone, and cyclohexanone; halogenated hydrocarbons such as dichloromethane, chloroform, tetrachloromethane, dichloroethane, trichloroethane, tetrachloroethane, chlorobenzene, dichlorobenzene, and chlorotoluene; esters such as ethyl acetate, butyl acetate, and amyl acetate; alcohols such as methanol, ethanol, propanol, butanol, pentanol, hexanol, cyclohexanol, methyl cellosolve, ethyl cellosolve, and ethylene glycol; ethers such as dibutyl ether, tetrahydrofuran, dioxane, and anisole; and polar solvents such as N,N-dimethylformamide, N,N-dimethylacetamide, 1-methyl-2-pyrrolidone, 1,3-dimethyl-2-imidazolidinone, and dimethyl sulfoxide. These solvents may be used either individually or as a mixture thereof.

The components may be dispersed finely by any method using, for example, a ball mill, a sand mill, a paint shaker, an attritor, or a homogenizer.
The concentration of the coating composition is not particularly limited and selected from a range decided as appropriate to the film formation method and a desired thickness. The concentration of the semiconductor compound in the coating composition is usually about 0.1 % to 50% by weight, preferably 1% to 30% by weight. The amount of the binder resin, if used, is not particularly limited and is usually from about 5% to 99.9% by weight, preferably from about 10% to 99% by weight, based on the amount of the semiconductor components forming each photoelectric layer (for example, based on the total amount of the semiconductor components forming the layers (1) to (3) when the photoelectric device has only one photoelectric layer).

As previously stated, the polyacene derivative represented by general formula (I), which is an organic semiconductor preferably used in the invention, is easily designable to have solvent solubility and is suitable to form a thin film by wet coating. This brings marked improvement of processability and productivity.

The photoelectric layer preferably, but not necessarily, has a thickness of about 5 nm to 5 µm.

In order to protect the device from contact with oxygen or moisture, a protective layer (a sealing layer) may be provided, or the device may be encapsulated with an inert substance such as paraffin, liquid paraffin, silicone oil, fluorocarbon oil, or zeolite-containing fluorocarbon oil.

Examples of the material making the protective layer include organic polymers, e.g., fluororesins, epoxy resins, silicone resins, epoxy silicone resins, polystyrene, polyester, polycarbonate, polyamide, polyimide, polyamide-imide, poly-p-xylene, polyethylene, and polyphenylene oxide; inorganic materials, e.g., diamond film, amorphous silica, electrically insulating glass, metal oxides, metal nitrides, metal carbides, and metal sulfides; and photocuring resins. These materials may be used either individually or as a combination of two or more thereof. The protective layer may have a single layer or a multi-layered structure.

The electrode may be protected with a metal oxide film (e.g., aluminum oxide film) or a metal fluoride film. The electrode may be provided on its surface with an interfacial layer (intermediate layer) made, e.g., of an organic phosphorus compound, polysilane, an aromatic amine derivative, a phthalocyanine derivative (e.g., copper phthalocyanine), or carbon. The electrode may be subjected to a surface treatment such as a treatment with an acid, ammonia/hydrogen peroxide, or plasma.

The photoelectric device of the invention is useful in not only those applications the conventional photoelectric devices have found, that is, as power sources for remote areas or auxiliary power sources for portable electronic equipment, but also all applications taking advantage of photoelectric conversion.

The process of producing the polyacene derivative represented by general formula (I), which is an organic semiconductor preferred in the present invention, will then be described. The polyacene derivative of general formula (I) is obtained by, for example, aromatizing a fused hydrocarbon ring represented by general formula (II) below in a solvent in the presence of a dehydrogenating reagent.

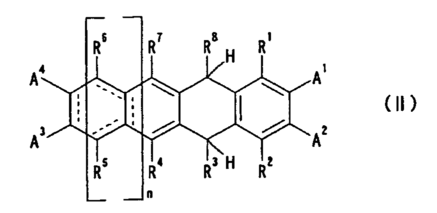

wherein R¹, R², R³, R⁴, R⁵, R⁶, R⁷, R⁸, A¹, A², A³, A⁴, and n are as defined above; and the bond indicated with a solid line and a dotted line represents a single bond or a double bond.

The fused hydrocarbon ring represented by general formula (II) is exemplified by those represented by formulae (IIa), (IIb), and (IIc) different in type of the bonds.

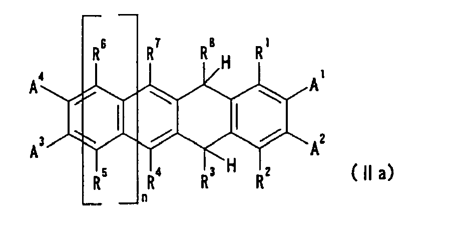

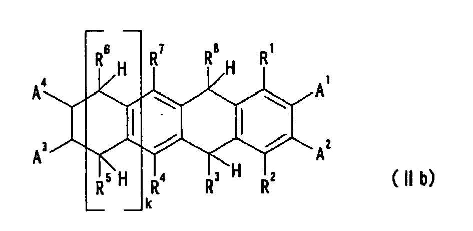

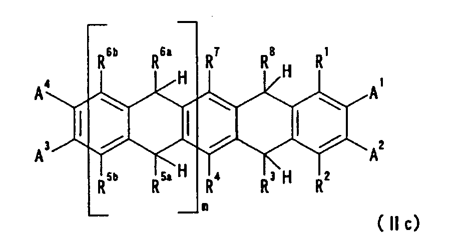

wherein R¹, R², R³, R⁴, R⁵, R⁶, R⁷, R⁸, A¹, A², A³, A⁴, and n are as defined above; R^{5a} and R^{5b} each have the same meaning as R⁵; and R^{6a} and R^{6b} each have the same meaning as R⁶.

When the fused hydrocarbon ring of formula (II) in which n is an odd number is represented by formula (IIb), k in formula (IIb) is an integer (n+1)/2. When the fused hydrocarbon ring of formula (II) in which n is an even number is represented by formula (IIc), m in formula (IIc) is an integer n/2.

When the fused hydrocarbon ring of formula (IIa) is aromatized to obtain the polyacene derivative of general formula (I), the number of the hydrocarbon rings to be aromatized is one. When in starting with the fused hydrocarbon ring of formula (IIb) or (IIc), that number is two or more.

The fused hydrocarbon rings represented by formula (II) include those in which an aromatic ring unit and a non-aromatic ring unit are fused at random.

The dehydrogenating reagent that can be used in the preparation of the polyacene derivative of general formula (I) is preferably a compound represented by formula (III):

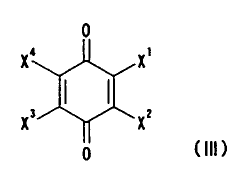

wherein X¹, X², X³, and X⁴ each independently represent a halogen atom or a cyano group.

The compound represented by formula (III) reacts with the fused hydrocarbon ring of formula (II) to become a corresponding 1,4-dihydroxycyclohexane derivative.

The halogen atom represented by X¹, X², X³, and X⁴ in formula (III) is preferably chlorine, bromine or iodine, more preferably chlorine or bromine, even more preferably chlorine. All of X¹, X², X³, and X⁴ can be chlorine. In that case, the compound of formula (III) is chloranil. Where X¹ and X² are each a cyano group, and X³ and X⁴ are each a chlorine atom, the compound of formula (III) is 2,3-dichloro-5,6-dicyanoquinone. All of X¹, X², X³, and X⁴ can be each a cyano group, in which case the compound of formula (III) is 2,3,5,6-tetracyanoquinone.

In the case of using the compound of formula (III) as a dehydrogenating reagent, a Diels-Alder reaction can occur between the compound of formula (II) and the polyacene derivative, the reaction product, to produce a by-product. In that case, the by-product is removed by column chromatography or a like means.
In order to avoid such by-production, it is advisable to use the compound of formula (III) in an amount of 0.9 to 1.2 equivalents, preferably 0.9 to 1.15 equivalents, more preferably 0.95 to 1.05 equivalents, to the compound of formula (II).

The solvent used in the aromatization reaction is preferably an organic solvent, particularly an aromatic compound such as benzene. The reaction temperature preferably ranges from -80° to 200°C, more preferably 0° to 100°C, even more preferably 10° to 80°C. If desired, the reaction system may be shielded from light during the progress of the reaction.

The dehydrogenating reagent that can be used in the preparation of the polyacene derivative of general formula (I) preferably contains palladium. For example, a commercially available product of palladium supported on carbon (e.g., activated carbon), i.e., Pd-on-C or Pd/C is suitably used. Pd/C is a catalyst widely employed for dehydrogenation, which can be used in the present invention in the same manner as in conventional dehydrogenation reactions. The reaction using Pd/C is usually carried out at a temperature ranging from 200° to 500°C, which can be adjusted appropriately according to the starting material and other various reaction conditions.

The fused hydrocarbon ring represented by formula (II) is obtained through the following reaction scheme:

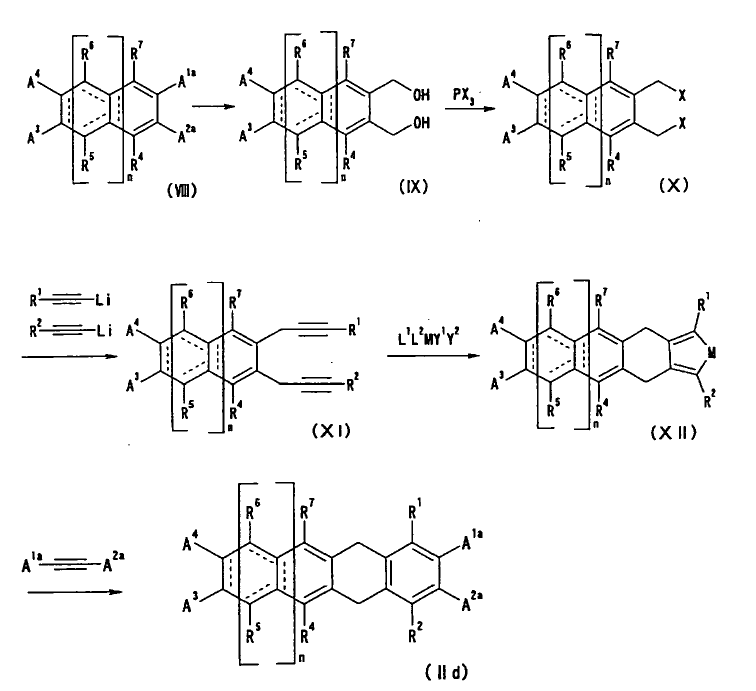

wherein R¹, R², R⁴, R⁵, R⁶, R⁷, A³, and A⁴, and n are as defined above; A^{1a} and A^{2a} each independently represent a C₆ to C₄₀ alkoxycarbonyl group which may have a halogen-containing substituent or a C₆ to C₄₀ aryloxycarbonyl group which may have a halogen-containing substituent; X represents a releasable group such as a halogen atom; the bond indicated by a solid line and a dotted line is a single bond or a double bond; M represents a metal of the groups 3 to 5 of the Periodic Table or a lanthanide series metal; L¹ and L² each independently represent an anionic ligand; L¹ and L² may be connected to each other; and Y¹ and Y² each independently represent a releasable group.

### Examples

The present invention will now be illustrated in greater detail with reference to Examples, but it should be understood that the present invention is not construed as being limited thereto. The compounds obtained in Synthesis Examples were used in Examples after being purified by sublimation or the like.

### Synthesis Example 1 - Compound 1

A commercially available compound (from Aldrich) having the structure shown below was used as compound 1.

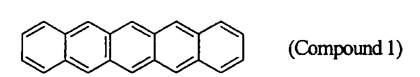

### Synthesis Example 2 - Synthesis of compound 2

Compound 2 shown below was synthesized as follows.

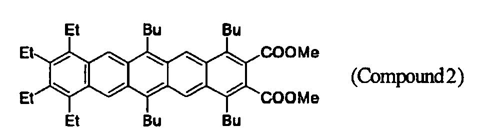

To zirconocene dichloride dissolved in THF was added two equivalents of n-butyl lithium at -78°C, followed by stirring for 1 hour. One equivalent of diyne 1 shown below was added thereto, followed by stirring at room temperature, whereupon zirconacyclopentadiene 1 below was formed. Two equivalents of CuCl, 3 equivalents of N,N-dimethylpropyleneurea (DMPU), and 1 equivalent of dimethylacetylene dicarboxylate (DMAD) were added to the reaction mixture, followed by stirring at 50°C for 3 hours to obtain a dihydro form of compound 2. The dihydro compound was caused to react with 1 equivalent of 2,3-dichloro-5,6-dicyanobenzoquinone (DDQ) to give compound 2.

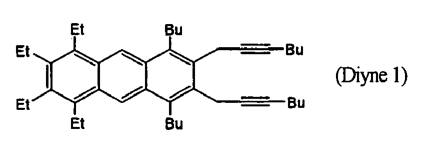

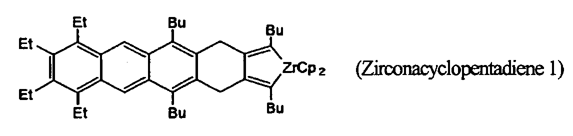

### Synthesis Example 3 - Synthesis of compound 3

Compound 3 shown below was synthesized in the same manner as in Synthesis Example 2, except for replacing diyne 1 with diyne 2 below.

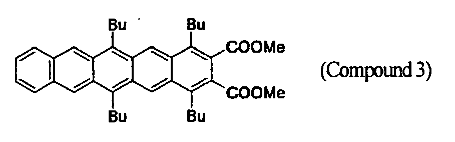

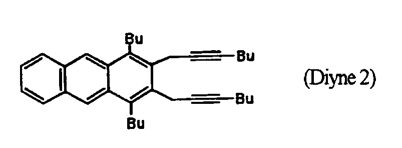

### Synthesis Example 4 - Synthesis of compound 4

Compound 4 below was synthesized as follows.

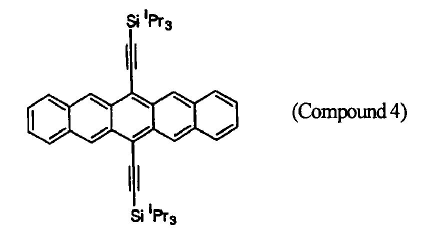

In accordance with the report of JACS, 2001, 123, 9482, a Grignard reagent synthesized from triisopropylacetylene and pentacenequinone were allowed to react with each other. The reaction mixture was treated with a hydrochloric acid aqueous solution containing tin chloride to give compound 4 as a blue solid.

### Synthesis Example 5 - Synthesis of compound 5

Compound 5 below was synthesized as follows.

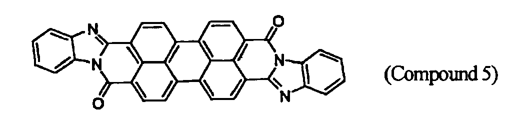

In 50ml of N-methylpyrrolidone, 3.7g (10mmol) of perylene 3,4,9,10-tetracarboxylic acid anhydride and 2.9g (25mmol) of o-phenylenediamine were allowed to react at 205°C for 18 hours. The reaction product slowly precipitated with the reaction progress. The precipitate was collected by filtration, washed by suspending four times with 50 ml portions of tetrahydrofuran, and dried to yield 4.5 g (80%) of compound 5.

### Synthesis Example 6 - Synthesis of compound 6

Compound 6 below was synthesized as follows.

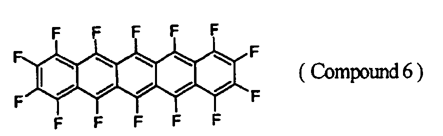

In accordance with the teachings of JACS, 2004, 126, 8138, tetrafluorophthalic anhydride and hydroquinone were allowed to react to form an anthracene derivative. The anthracene derivative was treated with tin to give 2,3-dihydro-1,4-anthracenedione, which was further allowed to react with tetrafluorophthalic anhydride to form 6,13-pentadenedione. The product was fluorinated with sulfur tetrafluoride, followed by treating with zinc to give compound 6.

### Organic compound for buffer layer:

Commercial products available from Tokyo Chemical Industry Co., Ltd. were used as buffer 1 and buffer 2. Buffer 3 was synthesized form 9-bromoanthracene (from Tokyo Chemical Ind., Co., Ltd.) through a Grignard reagent.

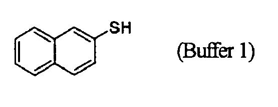

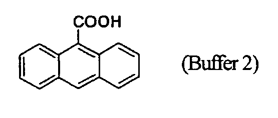

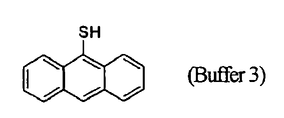

### Comparative compound:

Commercial products from Tokyo Chemical Ind., Co., Ltd. shown below were used as comparative compounds 1, 2, and 3.

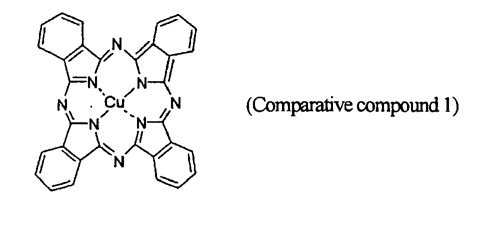

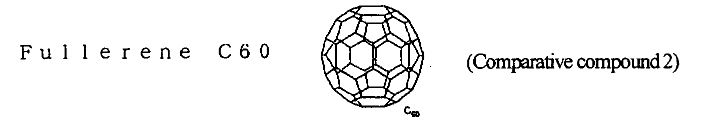

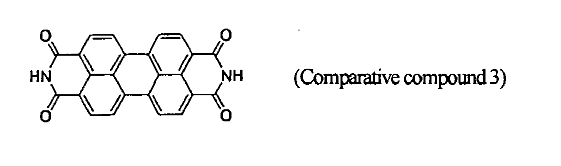

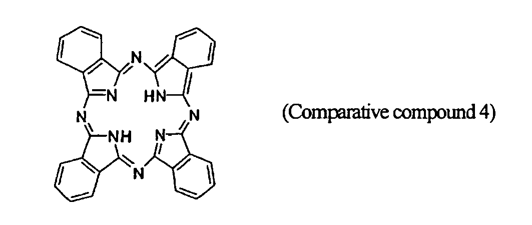

### Example 1

The charge mobility (carrier mobility) of compounds 1 to 6 and comparative compounds 1 to 3 was measured using an FET technique. In Table 1 are shown the kind of the carrier measured (electron or hole), the results of measurement, and the literature data (from Appl. Phys. Lett., 1998, 72, 1854-1856; J. Appl. Phys., 2004, 96, 769; Appl. Phys. Lett., 2003, 83, 3108; Appl. Phys. Lett., 2004, 84, 3789; J. Phys. Chem. B 107, 5877 (2003); and J. Phys. Chem. B, 2004, 108, 8614-8621).

**Table 1**

| Compound | Charge Mobility (cm²/V·sec) |
|---|---|
| Compound 1 | 0.18 (hole) |
| Compound 1 (literature data) | 0.21-5.0 (hole) |
| Compound 2 | 0.007 (hole) |
| Compound 3 | 0.009 (hole) |
| Compound 4 | 0.06 (hole) |
| Compound 6 | 0.01 (electron) |
| Comp. compound 1 | 0.002 (hole) |
| Comp. compound 2 | 0.001 (electron) |
| Comp. compound 3 | 0.0001 (electron) |

### Example 2

A glass substrate having a 130 nm thick transparent ITO electrode was patterned, cleaned by ultrasonication in a series of solvents (acetone, substrate cleaner, distilled water, and isopropyl alcohol) and then with UV/ozone, and set on the holder of a vacuum deposition system. The vacuum chamber was evacuated to about 10⁻⁴ Pa. The organic semiconductor compounds shown in Table 2 below were successively deposited using a mask for organic matter to form a p type semiconductor layer (1) to a thickness of 50 nm, a 1:1 (by volume) p type/n type mixed layer (2) to a thickness of 20 nm, and an n type semiconductor layer (3) to a thickness of 20 nm. A mask for electrode (effective area: 2 mm by 2 mm) was placed, and aluminum was deposited to form an electrode with a deposition thickness of about 100 nm. The photoelectric device thus obtained was evaluated for open circuit voltage (Voc), short circuit current (Isc), fill factor (FF), and conversion efficiency (CE) at a white light intensity of 100 mW/cm² by use of an instrument for evaluating photoelectric devices available from Bunko-Keiki Co., Ltd. The results obtained are shown in Table 2. In Tables hereinafter given, "cpd." stands for "compound".

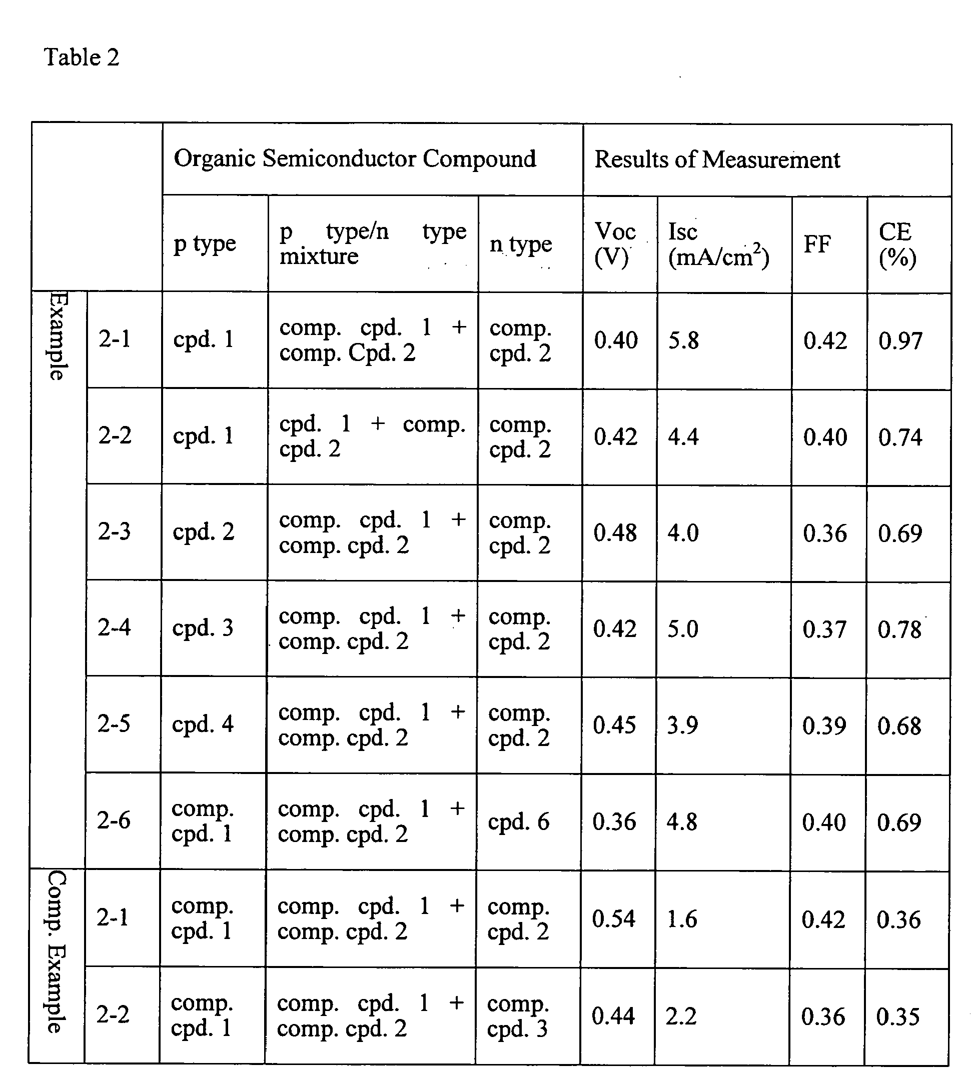

### Example 3

A substrate with a patterned transparent ITO electrode was cleaned and set on the substrate holder of a vacuum evaporation system in the same manner as in Example 2. Gold was deposited on the ITO electrode to a thickness of 5 nm. The substrate was then dipped in a 2% by mass solution of buffer 1 in THF, rinsed with THF, and dried in vacuo to form a buffer layer on the gold film. A solution of the p type organic semiconductor compound shown in Table 3 below in 1,2-dichloroethane was applied to the buffer layer and dried to form a 50 nm thick p type semiconductor layer (1). The substrate with the layer (1) was again set on the holder of the vacuum deposition system, and the 1:1 (by volume) p type/n type organic semiconductor compound mixture and the n type organic semiconductor compound shown in Table 3 were successively deposited to form a mixed semiconductor layer (2) to a thickness of 20 nm and an n type semiconductor layer (3) to a thickness of 20 nm, respectively. A mask for an electrode formation (effective area: 2 mm by 2 mm) was placed thereon, and aluminum was deposited to a thickness of about 100 nm. The thus prepared photoelectric device was evaluated in the same manner as in Example 2. The results obtained are shown in Table 3.

**Table 3**

| | Organic Semiconductor Compound | | | Results of Measurement | | | |
|---|---|---|---|---|---|---|---|
| | p type | p type/n type mixture | n type | Voc (V) | Isc (mA/cm²) | FF | CE (%) |
| Example 3-1 | cpd. 2 | comp. cpd. 1 + comp. Cpd. 2 | comp. cpd. 2 | 0.42 | 6.2 | 0.40 | 1.04 |
| Example 3-2 | cpd. 3 | comp. cpd. 1 + comp. cpd. 2 | comp. cpd. 2 | 0.43 | 4.7 | 0.39 | 0.79 |
| Example 3-3 | cpd. 4 | comp. cpd. 1 + comp. cpd. 2 | comp. cpd. 2 | 0.39 | 4.1 | 0.42 | 0.67 |
| Ref. Example | cpd. 1 | comp. cpd. 1 + comp. cpd. 2 | comp. cpd. 2 | film formation was impossible due to solvent insolubility | | | |
| Comp. Example 3-1 | comp. cpd. 1 | comp. cpd. 1 + comp. cpd. 2 | comp. cpd. 2 | film formation was impossible due to solvent insolubility | | | |

As noted in Table 3, use of compound 1 having no substituent used as a p type organic semiconductor compound fails to make a photoelectric device because it is insoluble in a solvent and therefore unable to form a thin film by a wet coating technique (Reference Example). In contrast, the compounds with substituents have high solubility and are able to form a thin film by a wet coating technique (Examples 3-1 to 3-3). It should be appreciated here that compound 1 is able to form a thin film by vacuum deposition to provide a photoelectric device exhibiting satisfactory characteristics as demonstrated in Example 2 (see Table 2).

### Example 4

A substrate with a transparent ITO electrode was patterned and cleaned in the same manner as in Example 2. Furthermore, the ITO electrode was treated with UV/ozone to have its work function increased by 0.5 eV. Thereafter, the organic semiconductor compounds shown in Table 4-1 below were successively deposited to form a p type semiconductor layer (1), a 1:1 (by volume) p type/n type mixed layer (2), and an n type semiconductor layer (3). A mask for electrode (effective area: 2 mm by 2 mm) was placed, and aluminum was deposited to form an about 100 nm thick electrode. The photoelectric device thus obtained was evaluated in the same manner as in Example 2. The results obtained are shown in Table 4-1. Additionally, energy gaps were obtained from the ionization potential of the films as measured by atmospheric photoelectron spectroscopy and the absorption spectrum of the films. The results are shown in Table 4-2.

**Table 4-1**

| | Organic Semiconductor Compound (film thickness; nm) | | | Results of Measurement | | | |
|---|---|---|---|---|---|---|---|
| | p type | p type/n type mixture | n type | Voc (V) | Isc (mA/cm²) | FF | CE (%) |
| Example 4-1 | comp. cpd. 1 (20 nm) | comp. cpd. 1 + comp. Cpd. 2 (20 nm) | 5 (20 nm) (20 nm) | 0.50 | 6.3 | 0.40 | 1.26 |
| Example 4-2 | cpd. 1 (50 mn) | comp. cpd. 1 + comp. cpd. 2 (20 mn) | cpd. 5 (10 mn) | 0.41 | 8.2 | 0.45 | 1.51 |
| Example 4-3 | comp. cpd. 4 (20 nm) | comp. cpd. 1 + comp. cpd. 2 (20 nm) | comp. cpd. 2 (20 nm) | 0.46 | 3.2 | 0.32 | 0.47 |

**Table 4-2**

| | Energy Gap (eV) | |
|---|---|---|
| | between Work Function of ITO Electrode and HOMO of p Type Semiconductor Layer (1) | between Work Function of Al Electrode and LUMO of n Type Semiconductor Layer (3) |
| Example 4-1 | 0 | 0 |
| Example 4-2 | 0.1 | 0 |
| Comp. Example 4-1 | 0.6 | 0.6 |

### Example 5

A substrate with a patterned transparent ITO electrode was cleaned and set on the substrate holder of a vacuum evaporation system in the same manner as in Example 2. Gold was deposited on the transparent ITO electrode to a thickness of 5 nm. The substrate was then dipped in a 2% by mass solution of buffer compound shown in Table 5 in THF, rinsed with THF, and dried in vacuo to form a buffer layer I on the gold film. A mask for organic matter was placed, and comparative compound 1, a 1:1 (by volume) mixture of comparative compound 1 and comparative compound 2, and comparative compound 2 were successively deposited to form a p type semiconductor layer (1) to a thickness of 20 nm, a p type/n type mixed layer (2) to a thickness of 20 nm, and an n type semiconductor layer (3) to a thickness of 20 nm, respectively. The buffer compound shown in Table 5 was deposited on the n type semiconductor layer (3) to a thickness of 1 nm to form a buffer layer II. A mask for electrode (effective area: 2 mm by 2 mm) was placed, and aluminum was deposited to form an electrode with a deposition thickness of about 100 nm, thereby to make a photoelectric device (Examples 5-1 to 5-4). The resulting devices were evaluated in the same manner as in Example 2. The results obtained are shown in Table 5.
Separately, a substrate with a transparent ITO electrode was cleaned in the same manner as in Example 2, and PEDOT-PSS (poly(ethylenedioxy)thiophene-polystyrene sulfonic acid) was applied thereon by spin coating to a film thickness of 30 nm and vacuum dried to form a buffer layer I having no chemical bond to the electrode. Then, comparative compound 1, a 1:1 (by volume) mixture of comparative compound 1 and comparative compound 2, and comparative compound 2 were successively deposited to form a p type semiconductor layer (1) to a thickness of 20 nm, a p type/n type mixed layer (2) to a thickness of 20 nm, and an n type semiconductor layer (3) to a thickness of 20 nm, respectively. A mask for electrode (effective area: 2 mm by 2 mm) was placed, and lithium fluoride was deposited to a thickness of 0.5 nm to form an inorganic buffer layer II. Aluminum was deposited thereon to form an electrode with a deposition thickness of about 100 nm, thereby to make a photoelectric device (Comparative Example 5-1). Further separately, a photoelectric device was made in the same manner as in Comparative Example 5-1, except that neither buffer layer I nor II was provided (Comparative Example 5-2). The resulting devices were evaluated in the same manner as in Example 2. The results obtained are shown in Table 5.

**Table 5**

| | Buffer Compound | | Results of Measurement | | | |
|---|---|---|---|---|---|---|
| | Buffer Layer I | Buffer Layer II | Voc (V) | Isc (mA/cm²) | FF | CE (%) |
| Example 5-1 | buffer 1 | none | 0.50 | 6.3 | 0.43 | 1.35 |
| Example 5-2 | buffer 2 | none | 0.46 | 6.7 | 0.37 | 1.14 |
| Example 5-3 | buffer 3 | none | 0.51 | 8.0 | 0.40 | 1.63 |
| Example 5-4 | none | buffer 1 | 0.54 | 7.7 | 0.38 | 1.58 |
| Comp. Example 5-1 | PEDOT-PSS | LiF | 0.46 | 3.6 | 0.35 | 0.58 |
| Comp. Example 5-2 | none | none | 0.47 | 3.3 | 0.32 | 0.50 |

### Example 6

A transparent ITO electrode was patterned, cleaned, and set on the substrate holder of a vacuum evaporation system in the same manner as in Example 2. Compound 1, a 1:1 (by volume) mixture of comparative compound 1 and comparative compound 2, comparative compound 2, and comparative compound 5 were successively deposited on the transparent ITO electrode to form a p type semiconductor layer (1) to a thickness of 60 nm, a p type/n type mixed layer (2) to a thickness of 20 nm, and n type semiconductor layers (3) to a thickness of 20 nm and 10 nm, respectively, to prepare photoelectric unit 1. Silver was deposited to a thickness of 0.5 nm to form an intermediate electrode.N,N'-Diphenyl-N,N'-di(m-tolyl)benzidine and tetrafluorotetracyanoquinodimethane were co-deposited at a molar ratio of 95:5 to a thickness of 5 nm. The procedure for making the photoelectric unit 1 was repeated once more to make photoelectric unit 2. Finally, silver was deposited to a thickness of 100 nm to prepare tandem photoelectric device A (Example 6-1). Photoelectric device A was evaluated in the same manner as in Example 2. The results obtained are shown in Table 6.
Separately, photoelectric unit 1 was made in the same manner as described above. ITO was sputtered thereon to form an intermediate electrode with a thickness of 10 nm. Photoelectric unit 2 was stacked thereon in the same manner as described above. Aluminum was vacuum deposited to a thickness of 100 nm to obtain tandem photoelectric device B (Example 6-2). Photoelectric device B was evaluated in the same manner as in Example 2. The results obtained are shown in Table 6.

**Table 6**

| | Structure | Results of Measurement | | | |
|---|---|---|---|---|---|
| | | Voc (V) | Isc (mA/cm²) | FF | CE (%) |
| Example 6-1 | tandem photoelectric device A | 0.80 | 5.6 | 0.42 | 1.88 |
| Example 6-2 | tandem photoelectric device B | 0.78 | 5.4 | 0.41 | 1.73 |

### Example 7

A transparent ITO electrode was patterned, cleaned, and set on the substrate holder of a vacuum evaporation system in the same manner as in Example 2. Compound 1 was vacuum deposited on the transparent ITO electrode to form a p type semiconductor layer (1) with a thickness of 10 nm. A solution prepared by dissolving a 1:1 mixture of compound 7 (P3HT) and compound 8 (PCBM) in dichlorobenzene was applied thereon by spin coating at a speed controlled so as to give a film thickness of 50 nm, 100 nm, 150 nm or 175 nm. After drying, comparative compound 5 was vacuum deposited to form an n type semiconductor layer (3) with a thickness of 10 nm. Aluminum was then deposited to a thickness of 100 nm to make a photoelectric device.
A photoelectric device was prepared in the same manner as described above, except that compound 1 was replaced with compound 2 or 4 and that the p type semiconductor layer (1) was formed by wet coating using a solution of compound 2 or 4 in toluene.
A photoelectric device was prepared in the same manner as described above, except that comparative compound 5 was not used. In this case, the photoelectric layer consisted of the p type semiconductor layer (1) and the p type/n type mixed semiconductor layer.
The results of evaluations of the resulting photoelectric devices are shown in Table 7.

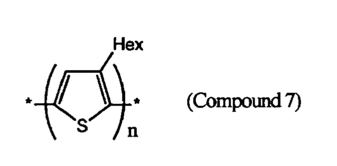

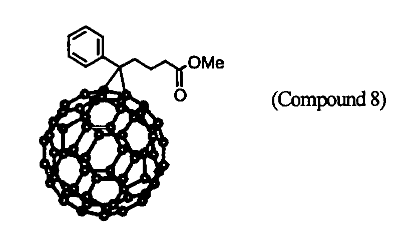

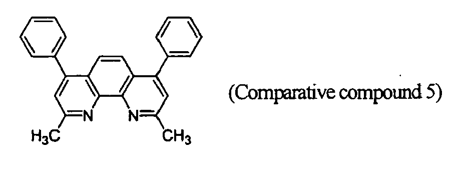

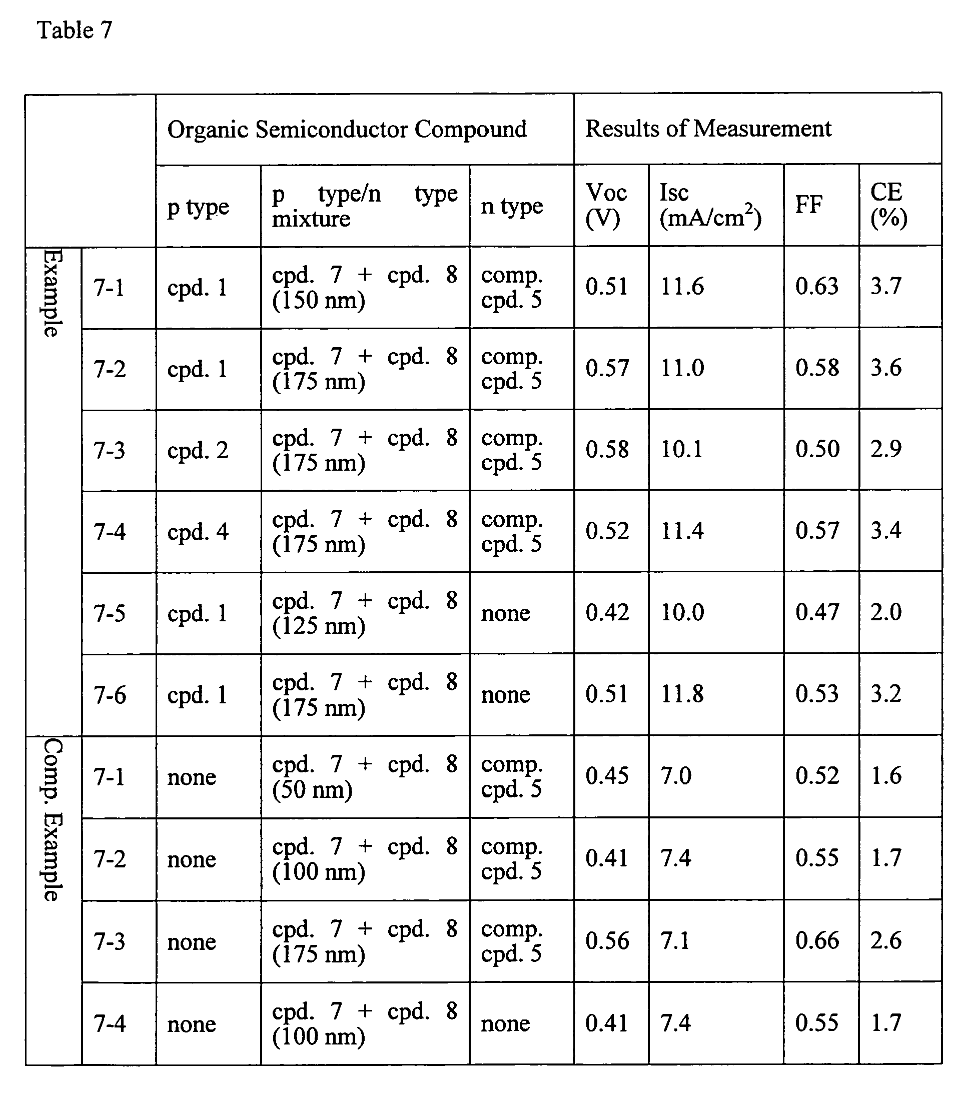

### Example 8

A transparent ITO electrode was patterned, cleaned, and set on the substrate holder of a vacuum evaporation system in the same manner as in Example 7. Compound 1 was vacuum deposited on the transparent ITO electrode to form a p type semiconductor layer (1) with a thickness of 10 nm. A solution prepared by dissolving a 1:1 mixture of compound 7 and compound 8 in dichlorobenzene was applied thereon by spin coating. After drying, a solution of titanium isopropoxide in water/isopropyl alcohol was applied to form a titanium oxide layer by a sol-gel process. Aluminum was vacuum deposited to a thickness of 100 nm to make a photoelectric device. The results of evaluation of the photoelectric device are shown in Table 8.

**Table 8**

| | Organic Semiconductor Compound | | metal oxide | Results of Measurement | | | |
|---|---|---|---|---|---|---|---|
| | p type | p type/n type mixture | | Voc (V) | Isc (mA/cm²) | FF | CE (%) |
| Example 8-1 | cpd.1 | cpd. 7+ cpd. 8 | TiO₂ | 0.34 | 10.9 | 0.39 | 1.46 |
| Comp. Example 8-2 | cpd. 1 | cpd. 7 + cpd. 8 | TiO₂ | 0.35 | 7.8 | 0.31 | 0.84 |

### Industrial Applicability

The present invention provides a photoelectric device having good processability/productivity, low toxicity, and satisfactory photoelectric conversion efficiency.

## Claims

1. A photoelectric device comprising a positive electrode and a negative electrode facing each other and a photoelectric layer interposed between the positive electrode and the negative electrode, the photoelectric layer having (1) a p type semiconductor layer, (2) a p type/n type mixed semiconductor layer, and (3) an n type semiconductor layer stacked in that order, the p type semiconductor of the p type semiconductor layer (1) and that of the mixed layer (2) being the same or different, and the n type semiconductor of the mixed layer (2) and that of the n type semiconductor layer (3) being the same or different, wherein
the photoelectric device has at least one of the following means for improving photoelectric efficiency:
(a) to use an organic semiconductor thin film having a charge mobility of 0.005 cm²/V·sec or more as at least one of the semiconductor layers (1) to (3);
(b) to control the energy gap between the work function of the positive electrode and the highest occupied molecular orbit (HOMO) of the p type semiconductor layer (1) and/or the energy gap between the work function of the negative electrode and the lowest unoccupied molecular orbit (LUMO) of the n type semiconductor layer (3) to 0.5 eV or less; and
(c) to provide a buffer layer of an organic compound between the positive electrode and/or the negative electrode and the photoelectric layer, the buffer layer and the positive electrode and/or the negative electrode being chemically bonded to each other.

2. A photoelectric device comprising a positive electrode and a negative electrode facing each other and a photoelectric layer interposed between the positive electrode and the negative electrode, the photoelectric layer having (1) a p type semiconductor layer and (2) a p type/n type mixed semiconductor layer stacked on each other, the p type semiconductor of the p type semiconductor layer (1) and that of the mixed layer (2) being the same or different, wherein
the photoelectric device has at least one of the following means for improving photoelectric efficiency:
(a) to use an organic semiconductor thin film having a charge mobility of 0.005 cm²/V·sec or more as at least one of the semiconductor layers (1) and (2);
(b) to control the energy gap between the work function of the positive electrode and the highest occupied molecular orbit (HOMO) of the p type semiconductor layer (1) and/or the energy gap between the work function of the negative electrode and the lowest unoccupied molecular orbit (LUMO) of the n type semiconductor layer (3) to 0.5 eV or less; and
(c) to provide a buffer layer of an organic compound between the positive electrode and/or the negative electrode and the photoelectric layer, the buffer layer and the positive electrode and/or the negative electrode being chemically bonded to each other.

3. A photoelectric device comprising a positive electrode and a negative electrode facing each other and a photoelectric layer interposed between the positive electrode and the negative electrode, the photoelectric layer having (1) a p type semiconductor layer, (2) a p type/n type mixed semiconductor layer, and (3) a metal oxide layer stacked in that order, the p type semiconductor of the p type semiconductor layer (1) and that of the mixed layer (2) being the same or different, wherein
the photoelectric device has at least one of the following means for improving photoelectric efficiency:
(a) to use an organic semiconductor thin film having a charge mobility of 0.005 cm²/V·sec or more as at least one of the semiconductor layers (1) and (2);
(b) to control the energy gap between the work function of the positive electrode and the highest occupied molecular orbit (HOMO) of the p type semiconductor layer (1) and/or the energy gap between the work function of the negative electrode and the lowest unoccupied molecular orbit (LUMO) of the n type semiconductor layer of the mixed layer (2) to 0.5 eV or less; and
(c) to provide a buffer layer of an organic compound between the positive electrode and/or the negative electrode and the photoelectric layer, the buffer layer and the positive electrode and/or the negative electrode being chemically bonded to each other.

4. The photoelectric device according to any one of claims 1 to 3, which adapts at least the means (a) of using an organic semiconductor thin film having a charge mobility of 0.005 cm²/V·sec or more as at least one of the semiconductor layers.

5. The photoelectric device according to any one of claims 1 to 4, wherein the p type semiconductor layer is an organic semiconductor thin film having a charge mobility of 0.005 cm²/V·sec or more.

6. The photoelectric device according to claim 4 or 5, comprising a plurality of photoelectric units each comprising the photoelectric layer having the semiconductor layers, every adjacent photoelectric units being separated with a layer that forms an equipotential surface and/or a charge generation layer as an intermediate electrode.

7. The photoelectric device according to any one of claims 1 to 3, which adapts at least the means (b) for improving photoelectric efficiency.

8. The photoelectric device according to any one of claims 1 to 3, which adapts at least the means (c) for improving photoelectric efficiency.

9. The photoelectric device according to any one of claims 1 to 8, wherein the p type semiconductor layer (1) of the photoelectric layer has a thickness of 10 nm or greater.

10. The photoelectric device according to any one of claims 1 to 9, wherein at least one of the organic semiconductor compounds used in the semiconductor layers is selected from polyacene derivatives represented by general formula (I): 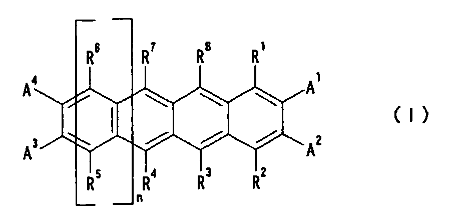 wherein R¹, R², R³, R⁴, R⁵, R⁶, R⁷, R⁸, A¹, A², A³, and A⁴ each independently represent a hydrogen atom, a halogen atom, a substituted or unsubstituted C₁ to C₄₀ hydrocarbon group, a substituted or unsubstituted C₁ to C₄₀ alkoxy group, a substituted or unsubstituted C₆ to C₄₀ aryloxy group, a substituted or unsubstituted C₇ to C₄₀ alkylaryloxy group, a substituted or unsubstituted C₂ to C₄₀ alkoxycarbonyl group, a substituted or unsubstituted C₇ to C₄₀ aryloxycarbonyl group, a cyano group (-CN), a carbamoyl group (-C(=O)NH₂), a haloformyl group (-C(=O)-X, wherein X represents a halogen atom), a formyl group (-C(=O)-H), an isocyano group, an isocyanate group, a thiocyanate group, a thioisocyanate group, a substituted or unsubstituted amino group, a substituted or unsubstituted amide group, a hydroxyl group, a substituted or unsubstituted silyl group, a substituted or unsubstituted thienyl group, or a functional group containing at least two of the groups recited; A¹ and A², or A³ and A⁴ may be connected to each other to form a ring represented by formula: -C(=O)-B-C(=O)- (wherein B is an oxygen atom or a group -N(B¹)- (wherein B¹ is a hydrogen atom, a C₁ to C₄₀ hydrocarbon group, or a halogen atom)); A³ and A⁴ may be connected to each other to form a saturated or unsaturated, and substituted or unsubstituted C₄ to C₄₀ ring which may be interrupted with an oxygen atom, a sulfur atom or a group -N(R¹¹)-(wherein R¹¹ is a hydrogen atom or a hydrocarbon group); and n is an integer of 1 or greater.

11. The photoelectric device according to any one of claims 1 to 10, wherein at least one of the p type semiconductor layer (1), the p type/n type mixed semiconductor layer (2), and the n type semiconductor layer or metal oxide layer (3) is formed by a wet coating method.
